# EUROPEAN PATENT APPLICATION

(11) **EP 4 586 496 A1**
(43) Date of publication of application: **16.07.2025**
(21) Application number: 23863462.0
(22) Date of filing: 05.09.2023
(51) Int. Cl.: H02S 40/32, H02S 50/00, G01R 35/00, G01R 31/12, G01R 19/165, G01R 19/00, G01R 23/00

(54) **ARC FAULT DETECTION DEVICE AND METHOD FOR CONTROLLING SAME**

(30) Priority: 05.09.2022 KR 20220111823; 31.08.2023 KR 20230115487
(71) Applicant: Hanwha Solutions Corporation, Jung-gu Seoul 04541 (KR)
(72) Inventor: LEE, Joonmin, Seoul 04541 (KR); HYUN, Dong Yub, Seoul 04541 (KR); JO, Yeongmin, Seoul 04541 (KR); AHN, Eunji, Seoul 04541 (KR); YU, Min-ho, Seoul 04541 (KR); AHN, Minho, Seoul 04541 (KR); KIM, Byungjun, Seoul 04541 (KR)
(74) Representative: Mooser, Sebastian Thomas
(86) International application number: PCT/KR2023/013234
(87) International publication number: WO 2024/053990

(57) **Abstract**

**The** disclosure relates to an arc fault circuit interrupt capable of detecting an arc fault and a method of controlling the device. **The** arc fault circuit interrupt according to the disclosure is shipped in a factory reset state in which all functions are initialized after a test to check for functional abnormalities, and when receiving an update instruction from an authorized administrator after being installed in the field, receives an update file from a management device such as an energy management system to proceed with a firmware update and activates an arc fault detection function, thereby having the effect of preemptively preventing unauthorized copying of the arc fault circuit interrupt.

## Description

### Technical Field

The disclosure relates to a device including an arc detection function and a control technology for utilizing the device.

### Background Art

A photovoltaic power generation system is a system which converts photovoltaic energy into electrical energy using a photovoltaic cell to transmit the electrical energy to a commercial power grid. Photovoltaic power generation is an environmentally friendly power generation method which does not cause environmental pollution in the process of the photovoltaic power generation and may be used semi-permanently, causing the share of the photovoltaic power generation gradually increasing.

As the installation and power generation amount of a photovoltaic power generation system increase, the frequency of problems with a photovoltaic power generation system is also increasing. In particular, there is always a possibility of unexpected arcing in electrical wiring of a photovoltaic power generation system, in a plurality of connectors used to connect photovoltaic panels to each other, or the like, and an arc may cause fires in a photovoltaic power generation system and major property damage.

Because such an arc fault may occur in a variety of environments, including large-scale photovoltaic installations as well as small-scale residential photovoltaic installations, detecting an arc fault and preemptively interrupting an arc is a critical element in ensuring the safe operation of any system in which an arc may potentially occur.

Therefore, a photovoltaic power generation system requires an arc fault circuit interrupt (AFCI) which may block an arc fault.

However, current arc detection algorithms are all focused on the implementation and detection method of AFCI, and there is a problem that there is no specific presentation on how the AFCI is applied and implemented in an actual product.

Therefore, there is a need for development of specific operation and control of an arc fault circuit interrupt performing a function of AFCI from production to operation.

### Disclosure

### Technical Problem

The purpose of the disclosure is to provide an arc fault circuit interrupt and a control method thereof optimized so that a series of procedures from production to installation and operation may be carried out efficiently.

### Technical Solution

A control method of an arc fault circuit interrupt according to the disclosure includes:
performing current correction for arc fault detection and storing a current correction value in an internal memory; performing a pre-test of arc fault detection; performing a factory reset in which a storage value of the memory except for the current correction value is deleted; receiving an update file from a management device through a wired/wireless communication interface when an update confirmation instruction is received after the arc fault circuit interrupt is installed; applying the update file which has been transmitted; and starting arc fault detection when an arc fault detection activation instruction is received from the management device.

An arc fault circuit interrupt according to another embodiment of the disclosure includes:
a current input unit for arc fault detection; and a control unit including one or more processors, memories, and communication units, wherein
the control unit is configured to perform current correction for arc fault detection and store a current correction value in the memory of the arc fault circuit interrupt, perform a pre-test of arc fault detection, perform a factory reset in which a storage value of the memory except for the current correction value is deleted, receive an update file from a management device when an update confirmation instruction is received through the communication unit after the arc fault circuit interrupt is installed, apply the update file which has been transmitted, and start arc fault detection when an arc fault detection activation instruction is received from the management device.

### Advantageous Effects of the Disclosure

According to an embodiment of the disclosure, by providing an optimal control technology from production to operation of an arc fault circuit interrupt, there is an advantage in that an arc may be effectively detected and a system including an arc fault circuit interrupt may be protected from risks such as fire, electric shock, or the like which are caused by arcing.

### Brief Description of Drawings

FIG. 1 is a circuit diagram illustrating a configuration of a PV inverter system including an AFCI according to an embodiment of the disclosure.
FIG. 2 is a block diagram illustrating a typical arc detection algorithm.
FIG. 3 is a flowchart illustrating a method for AFCI current correction and remote update in each process step according to an embodiment of the disclosure.

### Mode for Carrying Out the Disclosure

The above objects, means and effects of the present invention will become more apparent through the following detailed description with reference to the attached drawings, whereby a person having ordinary skill in the art to which the present invention pertains will be able to easily implement the technical idea of the present invention. In addition, when describing the disclosure, in case that it is determined that detailed description of the prior art related to the disclosure may unnecessarily obscure the gist of the disclosure, the detailed description will be omitted.

In the specification, the terms "or", "at least one", or the like may represent one of the words listed together or a combination of two or more. For example, "or B" or "at least one of B" may include only one of A or B or may include both A and B.

In the specification, the terms such as "first," "second," or the like may be used to describe various components, but the components should not be limited by these terms. In addition, the terms mentioned above should not be construed to limit the order of each component but may be used to distinguish a component from another. For example, a "first component" may be named a "second component", and similarly, the "second component" may also be named the "first component".

Hereinafter, a preferred embodiment of the disclosure will be described in detail with reference to the attached drawings.

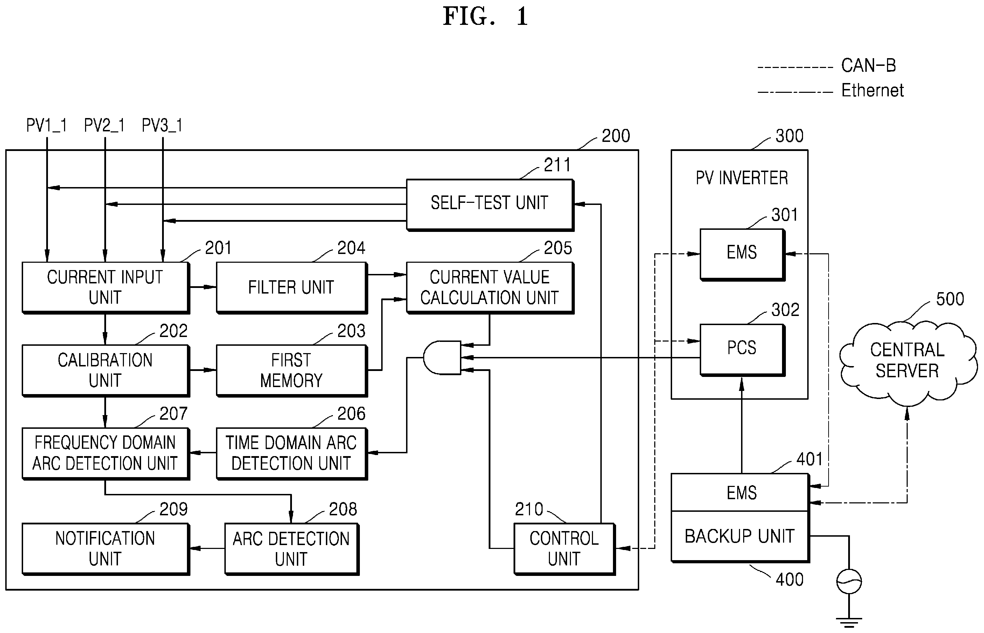

FIG. 1 may illustrate an overall configuration of a photovoltaic (PV) inverter system including an arc fault circuit interrupt according to an embodiment of the disclosure.

Although a photovoltaic inverter system has been used as an example for explanation, it is of course applicable to other systems including an arc fault circuit interrupt.

The photovoltaic inverter system may be configured to include an arc fault circuit interrupt (AFCI) 200, a PV inverter 300, a backup unit 400, a central server 500, or the like.

The arc fault circuit interrupt (AFCI) 200 may receive current measurement values PV1_I, PV2_I, and PV3_I of photovoltaic power generation panels to predict in advance whether an arc will occur by an arc detection algorithm.

The PV inverter 300 may convert the generated current of a photovoltaic power generation panel and control the arc fault circuit interrupt 200, including an energy management system (EMS) 301 and a power conversion system (PCS) 302.

The EMS 301 of the PV inverter 300 may store an update file such as firmware in advance, which would be used in the arc fault circuit interrupt 200, and when the arc fault circuit interrupt 200 is installed in the field and ready for use, the update file may be transmitted to the arc fault circuit interrupt 200 so that the arc fault circuit interrupt 200 may perform operation for arc fault detection.

The PCS 302 may perform power conversion through control of the EMS 301. For example, the PCS 302 may convert direct current power generated from a photovoltaic panel into alternating current power to be transmitted to a commercial power grid. In addition, the PCS 302 may monitor information about the converted power.

The backup unit 400 is a standby device equipped with an EMS 401 which may perform the same function as the EMS 301 of the PV inverter 300 in preparation for failure of the PV inverter 300.

The central server 500 may monitor a condition of a PV inverter system including the arc fault circuit interrupt 200, detect an abnormal condition, provide information about the condition to a user, and remotely perform control of the PV inverter system. For example, the central server 500 may be a cloud server.

When looking at the arc fault circuit interrupt 200 in more detail, the interrupt may include a current input unit 201, a calibration unit 202, a first memory 203, a filter unit 204, a current value calculation unit 205, a time domain arc detection unit 206, a frequency domain arc detection unit 207, an arc detection unit 208, a notification unit 209, a control unit 210, and a self-test unit 211.

The current input unit 201 may receive the generated current of a photovoltaic panel, which is measured by a current sensor. At this time, the current sensor may be arranged on each of a plurality of solar panels to measure the generated current.

Meanwhile, the generated current value measured by the current sensor may have an error depending on the environment in which a photovoltaic panel is installed or the characteristics of the arc fault circuit interrupt 200 itself or the installation environment thereof.

The calibration unit 202 may calculate a precise current correction value to correct the error included in the generated current value input from the current input unit 201. This may be determined by the ratio of the steady state current value, which has been set, and the generated current value, which has been measured.

According to an embodiment of the disclosure, the calibration unit 202 may calculate a current correction value and apply the calculated current correction value to the generated current value which has been measured, thereby calculating an accurate generated current value regardless of the installation environment of the PV inverter system including the arc fault circuit interrupt 200 and increasing the arc detection sensitivity of the system. This may increase the reliability of the PV inverter system including the arc fault circuit interrupt 200.

The first memory 203 is an application domain memory, in which data required for the operation of the arc fault circuit interrupt 200 and the current correction value calculated by the calibration unit 202 may be stored. For example, the first memory 203 may include a flash memory, a hard-disc drive (HDD), a solid-state drive (SSD), a read only memory (ROM), or the like, and the memory may include a buffer, a random access memory (RAM), or the like.

The filter unit 204 may extract a value of a specific frequency band from the generated current value input from the current input unit 201. For example, the filter unit 204 may use a high-pass filter or a low-pass filter. Using a high-pass filter, only a high-frequency band signal may be extracted from current signals, and using a low-pass filter, only a low-frequency band signal may be extracted from the current signals.

The current value calculation unit 205 may calculate an accurate generated current value from the generated current value input from the current input unit 201. To this end, the current value calculation unit 205 may receive the generated current a value which has passed through the filter unit 204 and receive a current correction value stored in advance to correct the error in the current value from the first memory 203. The current value calculation unit 205 may calculate an accurate current value by applying a current correction value to the generated current value which has been received.

The time domain arc detection unit 206 may detect an arc from the time domain information of the current value calculated by the current value calculation unit 205. For example, in case that a normal current value is analyzed in the time domain, the value may generally show a normal distribution characteristic, but in case that an arc is included in the current, a point of abrupt decrease may occur in the time domain analysis result of the current value, thereby detecting the arc.

The frequency domain arc detection unit 207 may detect an arc from the frequency domain information of the current value calculated by the current value calculation unit 205. For example, in case that a normal current value is analyzed in the frequency domain, the value may generally show a flat value, but in case that an arc is included in the current, the arc may be detected by confirming that a frequency component of the current value increases rapidly at a certain frequency or across the entire frequency due to noise.

The arc detection unit 208 may detect whether an arc is included in the current, based on the information detected by the time domain arc detection unit 206 and the frequency domain arc detection unit 207. That is, the arc detection unit 208 may determine that an arc has been detected, in case that the current value decreases by more than a first reference change amount in the time domain or in case that the frequency component of the current value increases by more than a second reference change amount in the frequency domain.

In case that an arc is detected as a result of checking the current in the arc detection unit 208, the notification unit 209 may notify this through a visual or auditory signal. For example, the notification unit 209 may use a speaker which generates sound, a light such as a LED which generates light.

The control unit 210 may control the operation of the arc fault circuit interrupt 200.

For this purpose, the control unit 210 may include one or more processors, second memories, and communication units. The second memory is a boot domain memory, in which a command necessary for the initial operation of the arc fault circuit interrupt 200 may be stored.

At this time, the second memory and the first memory 203 described above may be the same memory. That is, data stored in the second memory may also be stored in the first memory 203 and vice versa.

The control unit 210 may be connected to the PV inverter 300 and a communication network via the communication unit. For example, the communication network may use control area network (CAN) but also various wired/wireless communication networks such as Ethernet or the like.

The control unit 210 may receive a signal regarding the operation of the PV inverter 300 from a management device such as an EMS 301 of the PV inverter 300. For example, the operation of the arc fault circuit interrupt 200 may be started or stopped by receiving a signal such as enable/disable from the PV inverter 300, and in case that a situation such as rapid shutdown (RSD) occurs, the arc fault circuit interrupt 200 may be stopped by receiving a shutdown command from the PV inverter 300.

For this operation, the control unit 210 may store necessary firmware in the second memory. Specifically, the control unit 210 may receive the firmware from an external device such as a PV inverter 300, a backup unit 400, a central server 500 or a cloud server through the communication unit.

The self-test unit 211 may test whether the arc fault circuit interrupt 200 is operating normally. That is, the self-test unit 211 may enable testing whether the arc fault circuit interrupt 200 is operating normally, by inputting a current value for testing rather than the generated current value from a solar panel into the current input unit 201.

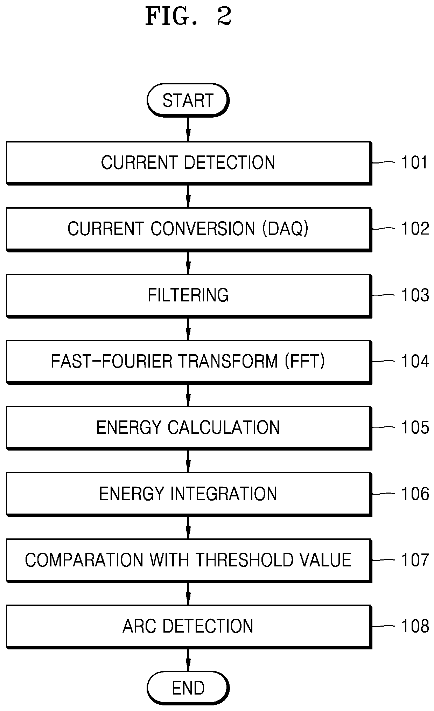

FIG. 2 shows an example of an arc detection method performed by an arc fault circuit interrupt 200.

For the conventional arc detection, current data may be digitized, the converted current data may be filtered to obtain a desired frequency component, and then the deviation in the time domain may be compared with a threshold value, thereby estimating the arc detection. After estimating the arc detection in the time domain, the current change amount in the frequency domain may be again subjected to the Discrete Fourier Transform (DFT) and then the deviation in the frequency domain may be compared with the threshold value, thereby detecting an arc.

FIG. 2 is a schematic flow diagram of another arc detection method.

First, current may be detected by a current sensor 101, and the current may be converted into digital data using an equipment of data acquisition (DAQ) such as an oscilloscope 102.

A bandpass filter may be applied to filter only the frequency domain from the converted data, in which an arc may be included, in the converted data 103, and the data may be converted into a frequency signal through a FAST-Fourier Transform (FFT) 104.

**The** energy for each frequency band may be calculated from the current signal converted into the frequency domain 105, the energy for each frequency band may be added 106, and the added energy value may be compared with a threshold value 107, thereby detecting an arc 108.

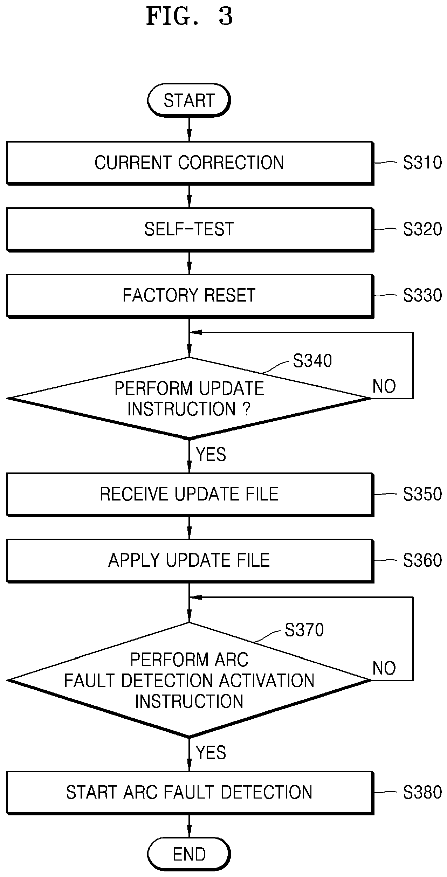

FIG. 3 is a schematic flow diagram of a control method of an arc fault circuit interrupt according to a preferred embodiment of the disclosure for efficiently operating such an arc fault circuit interrupt.

**The** control method of the arc fault circuit interrupt 200 may be performed by the control unit 210 including one or more processors and memories described above.

When the production of an arc fault circuit interrupt 200 begins, the correction of measurement current for the arc detection may become necessary because the characteristics of a device itself, such as a PCB board of each arc fault circuit interrupt, are different. Calibration, or current correction, of the current sensor of the arc fault circuit interrupt 200 produced for this purpose may be performed S310.

The current correction may be an essential step for high-precision operation of the arc fault circuit interrupt 200.

When the current correction of the current sensor is performed, a current correction value may be stored in the first memory 203 in the arc fault circuit interrupt 200 and then used for current calculation for subsequent arc detection.

After the current correction is completed, a pre-test of the arc fault circuit interrupt 200 may be performed S320.

The pre-test may be performed in a test environment where an actual arc may occur, but a simulated current signal may be generated using the self-test unit 211 described above, and the signal may be used to test whether the current correction value stored in the first memory 203 is appropriate, whether an arc may be normally detected by the corrected current value, or the like.

Such a simulated current signal may be operation mode data reflecting an operation situation in which the arc fault circuit interrupt 200 has been actually installed and used. Therefore, the accuracy of a current correction value may be confirmed more precisely by reflecting an actual operation environment through a pre-test.

After the pre-test is completed, a factory reset is performed S330, in which all functions of the arc fault circuit interrupt 200 are initialized.

This may be to ensure that the arc fault circuit interrupt 200 operates normally only when normally produced and installed and approved by a user with appropriate authority, such as an administrator.

When a factory reset is performed, the contents of the second memory in the control unit 210 where firmware for the operation of the arc fault circuit interrupt 200 is stored may be completely deleted. However, the first memory 203 in which a current correction value is stored may not be deleted. For this purpose, the first memory 203 and the second memory may be physically different memories.

Additionally, minimum program codes which perform operations such as subsequent firmware updates among the contents of the second memory may be preserved without being deleted.

In case that the first memory 203 and the second memory are the same memory, the remaining data except for the current correction value and the program codes for subsequent firmware updates may be deleted from the memory.

The arc fault circuit interrupt 200, in which a factory reset has been performed in this way, may not detect an arc fault until a firmware update is performed, even when installed in the system. Therefore, there is an effect of being able to protect the arc fault circuit interrupt 200 from theft, duplication, or the like.

The arc fault circuit interrupt 200 which has been completed with a factory reset may be shipped from the factory and installed in the required location.

After the installation is completed, the update confirmation instruction from the administrator may be waited for through the EMS 301 of the PV inverter 300 S340, and when the update confirmation instruction is received, the update file may be received S350.

The update confirmation instruction may be encrypted or include authentication means such as certificates or the like to verify whether the update confirmation instruction is made from an administrator with appropriate authority. The control unit 210 may verify this and proceed with the update only in case of a normal update confirmation instruction, thereby preventing use by theft or duplication in advance.

The update file may be a firmware file for the operation of the arc fault circuit interrupt 200 and may be received from the EMS 301 of the PV inverter 300 or may be received directly from the central server 500 or a cloud server. Therefore, the update file may be stored in advance in a management device such as the EMS 301 of the PV inverter 300 or the central server 500.

After receiving the update file normally, the firmware file may be stored and applied in the second memory in the control unit 210 of the arc fault circuit interrupt 200 to perform an arc fault detection operation. The firmware file may consist of a set of commands required for a processor operation of the control unit 210.

When the application of the update file is completed and normal operation of the arc fault circuit interrupt 200 is enabled, whether to activate arc fault detection may be received through the EMS 301 of the PV inverter 300 or the like S370, and then the arc fault circuit interrupt 200 may start current monitoring for arc detection to detect the arc S380.

Even after starting arc fault detection, in case that there is an arc fault detection deactivation instruction by RSD or the like, the arc fault detection may be stopped, and an arc fault detection activation instruction may be waited for again in S370.

In addition, even when the installation and update of the arc fault circuit interrupt 200 is completed and arc detection is being performed normally, there may be cases where an update of an arc detection algorithm or a modification of a current correction value may be required for more accurate operation.

In such a case, the arc fault detection may be stopped, and after waiting for an update instruction again in S340, a new update file may be received S350 and applied S360, thereby operating the arc fault circuit interrupt 200 by a new firmware or current correction value. Therefore, the accuracy of arc fault detection may be improved by the latest firmware or current correction value.

While the control method of the arc fault circuit interrupt 200 described above is being performed, data on false detection may be additionally collected to increase the accuracy of arc fault detection.

That is, in performing a pre-test by a simulated current signal or an actual test signal S320 or in performing arc fault detection in actuality by installing the arc fault circuit interrupt 200 S380, when arc false detection occurs, data on this may be collected and transmitted to the outside.

Data on arc false detection may be transmitted to an external central server 500 or cloud server for analysis, and the central server 500 or cloud server may update a current correction value or update firmware including an arc fault detection algorithm by reflecting arc false detection data received from a plurality of arc fault circuit interrupts.

In this way, the current correction value or firmware reflecting the analysis of arc false detection data may be transmitted from the central server to the arc fault circuit interrupt 200 through the EMS 301 or PCS 302, and the arc fault circuit interrupt 200 may reduce arc false detection by the updated firmware or current correction value. Therefore, the arc fault circuit interrupt 200 according to the disclosure, which may be updated periodically, may have the effect of continuously increasing the reliability of arc fault detection.

As described above, according to the control method of the arc fault circuit interrupt 200 according to the disclosure, a self-test of the arc fault circuit interrupt 200 before shipment may be possible, and because the interrupt may always be remotely updated to the latest status, there is an advantage in that an arc may be detected more efficiently and precisely.

Referring again to the arc fault circuit interrupt 200 of FIG. 1, an arc fault circuit interrupt 200 to which the control method of the arc fault circuit interrupt 200 described above is applied will be examined.

For the control method mentioned above to be applied, the arc fault circuit interrupt 200 may include a current input unit 201 and a control unit 210.

The current input unit 201 may receive a current signal from a solar panel or the like to detect an arc fault.

The control unit 210 may control the arc fault circuit interrupt 200 which performs arc fault detection using the current signal input from the current input unit 201.

For this purpose, the control unit 210 may include one or more processors, second memories, and communication units.

The control unit 210 may perform calibration to finely correct the current value received through the current input unit 201 and store the resulting current correction value in a first memory 203 of the arc fault circuit interrupt 200.

Using this current correction value, a pre-test may be performed before shipment from the factory, and when the test is completed, a factory reset may be performed to delete the values stored in the second memory, such as firmware or the like, except for the current correction value stored in the first memory 203, thereby completing preparation for shipment from the factory. Because the factory reset has been performed, the arc fault circuit interrupt 200 may not be operated normally.

After the arc fault circuit interrupt 200 is shipped from the factory and installed at the installation location, the arc fault circuit interrupt 200 may wait to receive an update instruction and after receiving an update confirmation instruction, an update file may be received from a management device such as an EMS, a central server, or the like and the file may be updated in the second memory of the control unit 210.

In case that the update file is received and the firmware update is completed normally, the arc fault circuit interrupt 200 may be finally ready for normal operation, and then in case that an arc fault detection activation instruction is received from the management device, the arc fault detection operation may be started.

In case that an arc false detection occurs during a pre-test or while performing an arc fault detection operation, the control unit 210 may also transmit data on arc false detection to an external central server or cloud server through the communication unit.

The central server or cloud server may collect arc false detection data and update current correction values or firmware reflecting the data, and the control unit 210 may receive the updated current correction values or firmware and perform an update of the arc fault circuit interrupt 200, thereby increasing the reliability of arc detection.

In this way, an arc fault circuit interrupt and a control method of the device according to the disclosure may have the advantage of being able to effectively control a series of operation methods, such as production and installation of an arc fault circuit interrupt.

Although the detailed description of the disclosure has described specific embodiments, it is of course possible to make various modifications without departing from the scope of the disclosure. Therefore, the scope of the disclosure should not be limited to the described embodiments, but should be defined by claims described below and the equivalents of the claims.

## Claims

1. A control method of an arc fault circuit interrupt (AFCI) performed by a control unit including one or more processors and a memory, **characterized by** comprising:
performing current correction for arc fault detection and storing a current correction value in the memory;
performing a pre-test of arc fault detection;
performing a factory reset in which a storage value of the memory except for the current correction value is deleted;
receiving an update file from a management device via a wired/wireless communication interface when an update confirmation instruction is received after the arc fault circuit interrupt is installed;
applying the update file which has been transmitted; and
starting arc fault detection when receiving an arc fault detection activation instruction from the management device.

2. The control method of an arc fault circuit interrupt of claim 1, wherein the update file is stored in advance in the management device.

3. The control method of an arc fault circuit interrupt of claim 1, wherein the received update confirmation instruction includes an authentication means capable of confirming authenticity of the update confirmation instruction.

4. The control method of an arc fault circuit interrupt of claim 1, wherein the update file includes firmware of the arc fault circuit interrupt.

5. The control method of an arc fault circuit interrupt of claim 1, wherein performing the pre-test of arc fault detection is performing by operation mode data reflecting an actual operation situation of an arc fault circuit interrupt.

6. The control method of an arc fault circuit interrupt of claim 1,
further comprising,
after starting the arc fault detection,
receiving a new current correction value from the management device through a wired/wireless communication interface and storing the same in the memory and
starting arc fault detection by the new current correction value.

7. An arc fault circuit interrupt, comprising:
a current input unit for arc fault detection; and a control unit including one or more processors, a memory and a communication unit, wherein
the control unit is configured to
perform current correction for arc fault detection and store a current correction value in the memory of the arc fault circuit interrupt,
perform a pre-test of arc fault detection,
perform a factory reset to delete a storage value of the memory except for the current correction value,
receive an update file from a management device when receiving an update confirmation instruction via the communication unit after the arc fault circuit interrupt is installed,
apply the update file which has been transmitted, and
start arc fault detection when receiving an arc fault detection activation instruction from the management device.

8. The arc fault circuit interrupt of claim 7, wherein
the update file is stored in advance in the management device.

9. The arc fault circuit interrupt of claim 7, wherein
the received update confirmation instruction includes an authentication means capable of confirming authenticity of the update confirmation instruction.

10. The arc fault circuit interrupt of claim 7, wherein
the update file includes firmware of the arc fault circuit interrupt.

11. The arc fault circuit interrupt of claim 7, wherein
the pre-test of arc fault detection is performing by operation mode data reflecting an actual operation situation of an arc fault circuit interrupt.

12. The arc fault circuit interrupt of claim 7, wherein
the control unit is configured to
receive a new current correction value from the management device through a wired/wireless communication interface and store the value in the memory after starting the arc fault detection and
start arc fault detection by the new current correction value.
